# FASCICULE DE BREVET EUROPEEN

(11) **EP 0 697 734 B1**
(45) Date de publication et mention de la délivrance du brevet: **24.10.2001**
(21) Numéro de dépôt: 95401802.4
(22) Date de dépôt: 01.08.1995
(51) Int. Cl.: H01L 27/02

(54) **Circuit de protection contre les décharges électrostatiques**
Schutzschaltung gegen elektrostatische Entladung
Electrostatic discharge protection circuit

(30) Priorité: 19.08.1994 FR 9410152
(43) Date de publication de la demande: 21.02.1996
(73) Titulaire: Atmel Grenoble S.A., 38120 Saint Egreve (FR)
(72) Inventeur: Thenoz, Yves, c/o Thomson-CSF, F-92402 Courbevoie Cédex (FR); Caranhac, Sophie, c/o Thomson-CSF, F-92402 Courbevoie Cédex (FR); Coutures, Jean-Louis, c/o Thomson-CSF, F-92402 Courbevoie Cédex (FR)
(74) Mandataire: Guérin, Michel

(56) Documents cités:
- EP-A- 0 549 320
- JP-A- 58 165 369
- US-A- 4 692 781
- PROCEEDINGS OF THE IEEE 1988 CUSTOM INTEGRATED CIRCUITS CONFERENCE, Mai 1988, ROCHESTER, NEW YORK, USA pages 27.2.1 - 27.2.4, XP43942 Q. SAY 'RESISTORLESS ESD PROTECTION DEVICE FOR HIGH SPEED CMOS CIRCUITS'
- PATENT ABSTRACTS OF JAPAN vol. 4, no. 165 (E-034) 15 Novembre 1980 & JP-A-55 113 359 (FUJITSU) 1 Septembre 1980

## Description

La présente invention concerne un circuit de protection contre les décharges électrostatiques.

De tels circuits de protection sont présents, par exemple, dans les circuits intégrés de technologie MOS (Métal Oxyde semiconducteur).

Comme cela est connu de l'homme de l'art, l'isolant de grille de faible épaisseur des transistors MOS peut devenir brutalement conducteur lorsque le champ électrique qui lui est appliqué dépasse une certaine valeur dite valeur de claquage. Il s'en suit une détérioration pouvant aller jusqu'à la destruction des transistors. Des circuits de protection sont alors conçus pour éviter ce phénomène.

Selon l'art antérieur, les circuits de protection sont de différents types.

Certains ne protègent que les circuits fonctionnant soit avec une tension de polarisation positive, soit avec une tension de polarisation négative. Il n'est alors pas possible de protéger les circuits polarisés à l'aide tensions positives et négatives.

D'autres dispositifs permettent une protection des circuits fonctionnant avec des tensions de polarisation positives et négatives. Parmi ces circuits, certains présentent une grande complexité. Il peut être alors nécessaire de former des caissons N dans un substrat P ou, réciproquement, des caissons P dans un substrat N. Un inconvénient est alors la nécessité d'avoir à polariser ces caissons.

D'autres circuits ont une structure moins complexe et permettent d'éviter la polarisation des caissons. Ces circuits ont pour schéma équivalent deux diodes montées tête-bêche. Une première diode est réalisée, par exemple, par une zone P+ dans un caisson N et une deuxième diode par la jonction que constituent alors le caisson N et le substrat P.

C'est le claquage des diodes par effet d'avalanche qui permet de limiter l'amplitude des tensions de décharge susceptibles de détériorer les circuits. La tension de claquage de la diode réalisée par la jonction du caisson N avec le substrat P est relativement élevée, par exemple de l'ordre de 100 volts. Il est très souvent nécessaire que la limitation de la tension de décharge s'effectue autour de valeurs plus faibles, par exemple de l'ordre de 15 à 20 volts. Comme cela est connu de l'homme de l'art, la tension de claquage est alors ajustée par des anneaux de garde, par exemple de type N⁺, réalisés par des surdopages situés en surface du composant. Il s'en suit que le claquage s'effectue aussi en surface. Ce type de protection est généralement peu efficace pour évacuer les courants dus aux décharges électrostatiques. Il est, d'autre part, sensible au vieillissement. Au fur et à mesure des claquages successifs, la diode se détériore et la tension de claquage évolue.

D'autres circuits sont décrits dans JP-A-58165369 et US-A-4 692 781.

La présente invention ne présente pas ces inconvénients.

La présente invention a pour objet un circuit de protection contre les décharges électrostatiques pouvant apparaître aux bornes d'un circuit, caractérisé en ce qu'il comprend un premier transistor réalisé dans un caisson dont le potentiel est flottant, ledit premier transistor permettant de limiter la valeur de la tension de décharge à une valeur égale à moins la valeur de sa tension de seuil et un deuxième transistor réalisé dans un caisson dont le potentiel est flottant, ledit deuxième transistor permettant de limiter la valeur de la tension de décharge à une valeur égale à la valeur de sa tension de seuil.

Un avantage de l'invention est d'éviter l'utilisation de circuits de protection tels que ceux mentionnés ci-dessus.

D'autres caractéristiques et avantages de l'invention apparaîtront à la lecture d'un mode de réalisation fait avec référence aux figures ci-annexées parmi lesquelles :
- la figure 1 représente une vue en coupe d'un circuit de protection selon un premier mode de réalisation de l'invention.
- la figure 2 représente une vue en coupe d'un circuit de protection selon un deuxième mode de réalisation de l'invention.

Sur toutes les figures, les mêmes repères désignent les mêmes éléments.

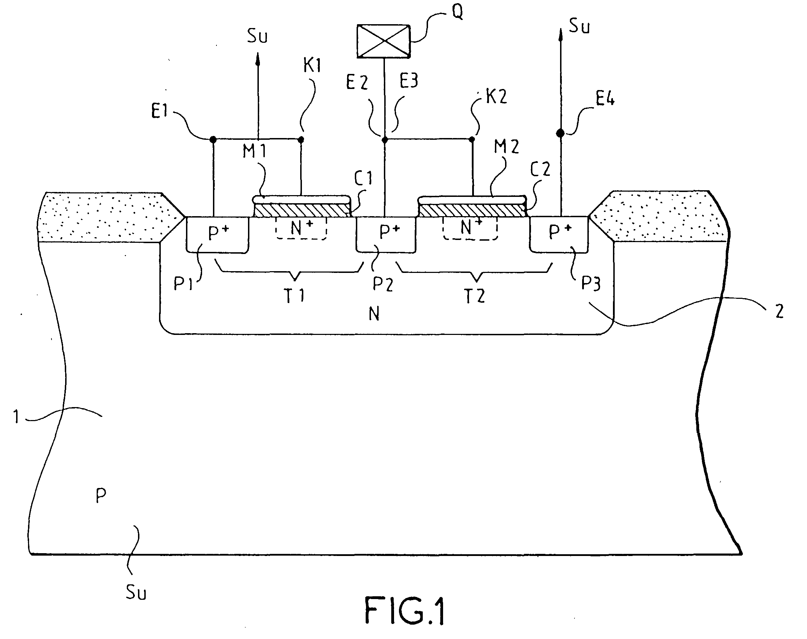

La figure 1 représente une vue en coupe d'un circuit de protection selon un premier mode de réalisation de l'invention.

Dans un substrat 1 de type P est formé un caisson 2 de type N.

Selon l'invention, telle que revendiquée dans la revendication 1 le caisson 2 n'est relié à aucune polarisation extérieure et se trouve donc à un potentiel flottant.

Trois zones dopées P⁺, P1, P2, P3, sont créées en surface du caisson 2. Comme représenté en figure 1, les trois zones P1, P2, P3 sont préférentiellement alignées et la zone P2 est située entre les zones P1 et P3. Une couche diélectrique isolante C1 recouvre la surface du caisson située entre les zones P1 et P2. De même une couche diélectrique isolante C2 recouvre la surface du caisson située entre les zones P2 et P3. La couche diélectrique C1 est recouverte d'une couche conductrice M1 et la couche diélectrique C2 d'une couche conductrice M2. Il s'en suit que, d'une part, les zones P1 et P2 constituent les électrodes principales d'un premier transistor MOS de type P, référencé T1, dont l'électrode de commande est constituée par la couche conductrice M1 et que, d'autre part, les zones P2 et P3 constituent les électrodes principales d'un deuxième transistor MOS de type P, référencé T2, dont l'électrode de commande est constituée par la couche conductrice M2.

Les deux électrodes principales du transistor T1 sont notées E1 et E2 et correspondent aux zones dopées P⁺ respectives P1 et P2. Les deux électrodes principales du transistor T2 sont notées E3 et E4 et correspondent aux zones dopées P⁺ respectives P2 et P3. Les électrodes principales E2 et E3 sont donc confondues et correspondent à la zone P⁺ notée P2. L'électrode de commande du transistor T1 est notée K1 et l'électrode de commande du transistor T2 est notée K2.

Comme cela a été mentionné précédemment, chaque électrode de commande (K1, K2) est constituée d'une couche diélectrique isolante (C1, C2) recouverte d'une couche conductrice (M1, M2). La couche diélectrique isolante peut être soit une couche mince réalisée avec un diélectrique de nature identique à celle utilisée pour réaliser les grilles des circuits à protéger, soit une couche d'oxyde épaisse.

Dans le premier cas, c'est-à-dire lorsque la couche diélectrique est une couche mince réalisée avec un diélectrique de nature identique à celle utilisée pour les grilles des transistors à protéger, des zones N⁺ sont implantées dans les zones semiconductrices N situées sous les électrodes de commande de façon à élever la valeur absolue des tensions de seuil des transistors T1 et T2. Comme cela sera précisé ultérieurement le dopage N⁺ est effectué de façon à obtenir, par exemple, des tensions de seuil de valeurs absolues identiques de l'ordre de 17 volts. De façon plus générale, l'invention concerne cependant d'autres modes de réalisation pour lesquels les valeurs des tensions de seuil obtenues sont différentes. Afin d'éviter tout claquage parasite entre les zones P⁺ et les zones N⁺, les dopages N⁺ ne sont pas réalisés dans la totalité des zones N mais préférentiellement dans la partie centrale des zones N.

Dans le second cas, c'est-à-dire lorsque le diélectrique d'isolement est une couche d'oxyde épaisse, il peut être inutile d'implanter une zone N⁺ dans les zones situées sous les électrodes de commande. Seule la modification de l'épaisseur de la couche d'oxyde peut alors permettre d'ajuster la tension de seuil à la valeur désirée.

Selon l'invention l'électrode principale E1 et l'électrode de commande K1 sont reliées ensemble au potentiel de référence Su du substrat 1, l'électrode principale E4 est reliée au potentiel de référence Su du substrat 1, et les électrodes principales E2 et E3 et l'électrode de commande K2 sont reliés ensemble au même plot Q.

Le circuit de protection est monté en parallèle des circuits à protéger, lesquels sont donc situés entre le plot Q et le potentiel de référence Su du substrat 1.

Les transistors T1 et T2 ont des tensions de seuil respectives VT1 et VT2 d'amplitudes négatives. Comme cela a été mentionné précédemment, les valeurs des tensions VT1 et VT2 sont ajustées soit à l'aide du dopage N⁺ des zones N situées sous les couches diélectriques isolantes C1 et C2, soit par la variation d'épaisseur des couches diélectriques C1 et C2. A titre d'exemple, dans le cas du dopage N⁺, celui-ci est effectué de façon à obtenir des tensions de seuil de valeurs préférentiellement identiques, par exemple de l'ordre de 17 volts en valeur absolue.

Lorsqu'une décharge d'amplitude V positive par rapport au potentiel de référence du substrat 1 est appliquée au plot Q, Les électrodes E1 et E2 se comportent respectivement comme le drain et la source du transistor T1 et les électrodes E3 et E4 respectivement comme la source et le drain du transistor T2. Il s'en suit que le transistor T2 est bloqué et que le transistor T1 se met à conduire lorsque la tension de la décharge électrostatique atteint une valeur égale à moins la valeur de VT1.

De même lorsqu'une décharge d'amplitude V négative par rapport à la tension de référence du substrat 1 est appliquée au plot Q, les électrodes E1 et E2 se comportent respectivement comme la source et le drain du transistor T1 et les électrodes E3 et E4 respectivement comme le drain et la source du transistor T2. Il s'en suit que le transistor T1 est bloqué et que le transistor T2 se met à conduire lorsque la tension de la décharge électrostatique atteint la valeur de la tension de seuil VT2.

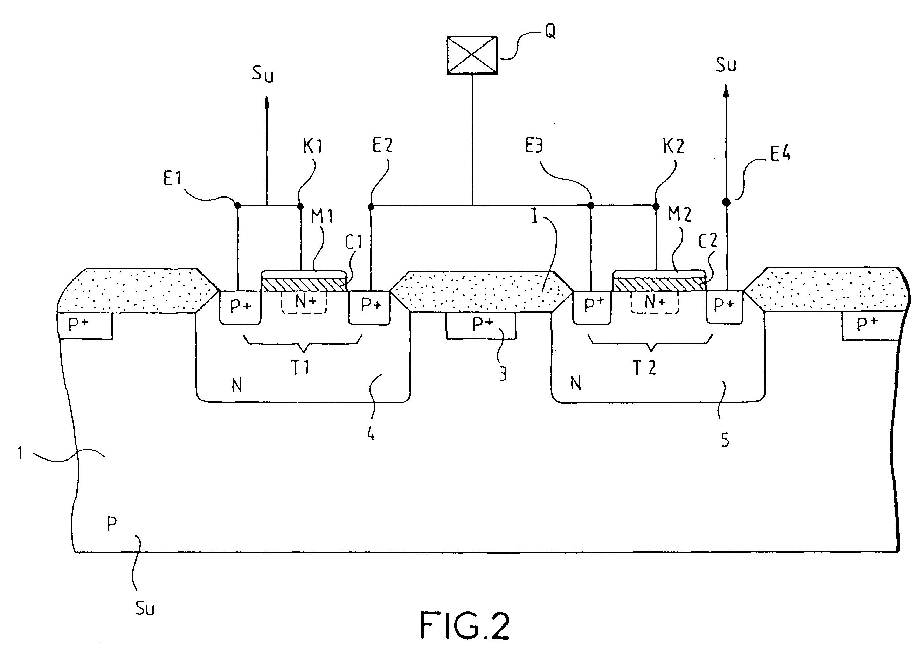

La figure 2 représente une vue en coupe d'un circuit de protection selon un deuxième mode de réalisation de l'invention.

Selon ce mode de réalisation, la zone P⁺ qui définit l'électrode principale E2 du transistor T1 est alors distincte de la zone P⁺ qui définit l'électrode principale E3 du transistor T2. Les transistors T1 et T2 sont alors réalisés dans deux caissons différents, respectivement notés 4 et 5 sur la figure 2. Selon l'invention ces caissons ne sont reliés à aucune polarisation extérieure et se trouvent donc à des potentiels flottants. Les électrodes E2 et E3 sont cependant toujours reliées entre elles et au même plot Q. La séparation des deux zones P⁺ est alors réalisée par une zone I d'isolation par oxyde épais. Une zone P⁺, référencée 3 sur la figure 2, est implantée dans le substrat P, sous la région I d'oxyde épais. Cette zone contribue à l'isolation des caissons 4 et 5 dans lesquels sont formés les transistors respectifs T1 et T2 en évitant en particulier la formation d'un canal parasite entre les caissons 4 et 5.

Comme représenté en figure 2, des zones P⁺ sont implantées de façon générale sous toutes les zones d'isolation par oxyde épais que comporte le circuit. Ces zones n'ont pas été représentées en figure 1 pour des raisons de commodité.

Un avantage de l'invention est de permettre la protection des circuits par mise en conduction de transistors MOS et non pas par phénomène d'avalanche de diodes. L'efficacité de la protection s'en trouve ainsi grandement améliorée de même que la fiabilité du composant.

Un autre avantage de l'invention est de permettre la protection de circuits non seulement en présence de tensions de polarisation positives et/ou négatives des circuits à protéger mais aussi en l'absence de toute polarisation extérieure.

Selon les deux modes de réalisation de l'invention décrits ci-dessus les deux transistors MOS de protection T1 et T2 sont des transistors à canal P induit réalisés dans un caisson de type N au sein d'un substrat de type P. L'invention concerne cependant aussi des transistors MOS de protection à canal N induit réalisés dans un caisson de type P au sein d'un substrat de type N.

## Revendications

1. Circuit de protection contre les décharges électrostatiques pouvant apparaître aux bornes d'un circuit, comprenant un premier et un second transistors MOS (T1, T2), comportant chacun deux électrodes principales et une électrode de commande, ledit premier transistor (T1) ayant une première électrode principale (E1) reliée à son électrode de commande (K1) et à une première borne du circuit à protéger, et une deuxième électrode principale (E2) reliée à une deuxième borne du circuit à protéger ledit premier transistor permettant de limiter la valeur de la tension de décharge à une valeur égale à moins la valeur de sa tension de seuil (VT1), et ledit deuxième transistor (T2) ayant une première électrode principale (E3) reliée à son électrode de commande (K2) et à la deuxième borne du circuit à protéger et une deuxième électrode principale (E4) reliée à la première borne du circuit à protéger, ledit deuxième transistor permettant de limiter la valeur de la tension de décharge à une valeur égale à la valeur de sa tension de seuil (VT2) dans lequel
- le premier transistor est réalisé dans un caisson à potentiel flottant par rapport à un substrat semiconducteur sur lequel le circuit est réalisé,
- et le deuxième transistor est réalisé dans un caisson à potentiel flottant par rapport au substrat.

2. Circuit de protection selon la revendication 1, **caractérisé en ce que** les premier et deuxième transistor (T1, T2) sont réalisés dans un même caisson (2) formé dans un substrat (1).

3. Circuit de protection selon la revendication 2, **caractérisé en ce que** ladite première borne est électriquement reliée audit substrat (1).

4. Circuit de protection selon l'une des revendications 2 et 3, **caractérisé en ce que** la deuxième électrode principale (E2) du premier transistor (T1) est confondue avec la première électrode principale (E3) du deuxième transistor (T2).

5. Circuit de protection selon la revendication 1, **caractérisé en ce que** le premier transistor (T1) est réalisé dans un premier caisson (4) et le deuxième transistor (T2) dans un deuxième caisson (5), lesdits premier et deuxième caisson étant formés dans un même substrat (1) et étant séparés par une zone (I) d'isolation par oxyde épais.

6. Circuit de protection selon la revendication 5, **caractérisé en ce que** la première borne est électriquement reliée audit même substrat(1).

7. Circuit de protection selon l'une quelconque des revendications 1 à 6, **caractérisé en ce que** les couches diélectriques (C1, C2) des électrodes de commande (K1, K2) desdits premier et deuxième transistors sont réalisées avec un diélectrique de nature identique à celle utilisée pour réaliser les grilles des circuits à protéger.

8. Circuit de protection selon la revendication 7, **caractérisé en ce que** les zones centrales semiconductrices situées sous lesdites couches diélectriques (C1, C2) sont surdopées de façon à élever la valeur absolue de la tension de seuil desdits premier et deuxième transistors.

9. Circuit de protection selon l'une quelconque des revendications 1 à 6, **caractérisé en ce que** les couches diélectriques (C1, C2) des électrodes de commande (K1, K2) desdits premier et deuxième transistors sont réalisés par une couche d'oxyde épaisse.

10. Circuit de protection selon l'une quelconque des revendications 1 à 9, **caractérisé en ce que** lesdits premier et deuxième transistors sont des transistors MOS de type P.

11. Circuit de protection selon l'une quelconque des revendications 1 à 9, **caractérisé en ce que** lesdits premier et deuxième transistors sont des transistors MOS de type N.

## Patentansprüche

1. Schutzschaltung gegen elektrostatische Entladungen, die an den Klemmen einer Schaltung auftreten können, mit einem ersten und einem zweiten MOS-Transistor (T1, T2), die je zwei Hauptelektroden und eine Steuerelektrode besitzen, wobei der erste Transistor (T1) eine erste Hauptelektrode (E1), die an die eigene Steuerelektrode (K1) und an eine erste Klemme der zu schützenden Schaltung angeschlossen ist, und eine zweite Hauptelektrode (E2) besitzt, die an eine zweite Klemme der zu schützenden Schaltung angeschlossen ist, und der erste Transistor den Wert der Entladespannung auf einen Wert von mindestens gleich dem Wert seiner Schwellspannung (VT1) begrenzen kann, während der zweite Transistor (T2) eine erste Hauptelektrode (E3), die an die eigene Steuerelektrode (K2) und an die zweite Klemme der zu schützenden Schaltung angeschlossen ist, und eine zweite Hauptelektrode (E4) besitzt, die an die erste Klemme der zu schützenden Schaltung angeschlossen ist, und der zweite Transistor den Wert der Entladespannung auf einen Wert gleich dem Wert seiner Schwellspannung (VT2) begrenzen kann,
- wobei der erste Transistor in einer Senke mit undefiniertem Potential bezüglich eines Halbleitersubstrats ausgebildet ist, auf dem die Schaltung ausgebildet ist,
- und wobei der zweite Transistor in einer Senke mit undefiniertem Potential bezüglich des Substrats ausgebildet ist.

2. Schutzschaltung nach Anspruch 1, dadurch gekenn-' zeichnet, daß der erste und der zweite Transistor (T1, T2) in einer gemeinsamen, in einem Substrat (1) ausgebildeten Senke (2)ausgebildet sind.

3. Schutzschaltung nach Anspruch 2, **dadurch gekennzeichnet, daß** die erste Klemme elektrisch mit dem Substrat (1) verbunden ist.

4. Schutzschaltung nach einem der Ansprüche 2 und 3, **dadurch gekennzeichnet, daß** die zweite Hauptelektrode (E2) des ersten Transistors (T1) mit der ersten Hauptelektrode (E3) des zweiten Transistors (T2) zusammenfällt.

5. Schutzschaltung nach Anspruch 1, **dadurch gekennzeichnet, daß** der erste Transistor (T1) in einer ersten Senke (4) und der zweite Transistor (T2) in einer zweiten Senke (5) ausgebildet ist, wobei die beiden Senken in einem gemeinsamen Substrat (1) ausgebildet sind und durch eine Isolationszone (I) aus einer dicken Oxidschicht voneinander getrennt sind.

6. Schutzschaltung nach Anspruch 5, **dadurch gekennzeichnet, daß** die erste Klemme elektrisch mit dem gemeinsamen Substrat (1) verbunden ist.

7. Schutzschaltung nach einem beliebigen der Ansprüche 1 bis 6, **dadurch gekennzeichnet, daß** die dielektrische Schicht (C1, C2) der Steuerelektroden (K1, K2) in den beiden Transistoren je mit einem Dielektrikum gleicher Art wie für die Bildung der Gates der zu schützenden Schaltungen realisiert sind.

8. Schutzschaltung nach Anspruch 7, **dadurch gekennzeichnet, daß** die zentralen halbleitenden Schichten, die sich unter den dielektrischen Schichten (C1, C2) befinden, so überdotiert sind, daß der Absolutwert der Schwellspannung der beiden Transistoren angehoben wird.

9. Schutzschaltung nach einem beliebigen der Ansprüche 1 bis 6, **dadurch gekennzeichnet, daß** die dielektrische Schicht (C1, C2) der Steuerelektroden (K1, K2) des ersten und des zweiten Transistors von einer dicken Oxidschicht gebildet werden.

10. Schutzschaltung nach einem beliebigen der Ansprüche 1 bis 9, **dadurch gekennzeichnet, daß** der erste und der zweite Transistor MOS-Transistoren vom Typ P sind.

11. Schutzschaltung nach einem beliebigen der Ansprüche 1 bis 9, **dadurch gekennzeichnet, daß** der erste und der zweite Transistor MOS-Transistoren vom Typ N sind.

## Claims

1. Circuit for protecting against electrostatic discharges that may occur at the terminals of a circuit, comprising first and second MOS transistors (T1, T2) each having two main electrodes and one control electrode, the said first transistor (T1) having a first main electrode (E1) connected to its control electrode (K1) and to a first terminal of the circuit to be protected and a second main electrode (E2) connected to a second terminal of the circuit to be protected, the said first transistor making it possible to limit the value of the discharge voltage to a value at least equal to the value of its threshold voltage (V_{T}1), and the said second transistor (T2) having a first main electrode (E3) connected to its control electrode (K2) and to the second terminal of the circuit to be protected and a second main electrode (E4) connected to the first terminal of the circuit to be protected, the said second transistor making it possible to limit the value of the discharge voltage to a value equal to the value of its threshold voltage (V_{T}2), in which protective circuit:
- the first transistor is made in a well having a floating potential with respect to a semiconductor substrate on which the circuit is made; and
- the second transistor is made in a well having a floating potential with respect to the substrate.

2. Protective circuit according to Claim 1, **characterized in that** the first and second transistors (T1, T2) are made in the same well (2) formed in a substrate (1).

3. Protective circuit according to Claim 2, **characterized in that** the said first terminal is electrically connected to the said substrate (1).

4. Protective circuit according to either of Claims 2 and 3, **characterized in that** the second main electrode (E2) of the first transistor (T1) is merged with the first main electrode (E3) of the second transistor (T2).

5. Protective circuit according to Claim 1, **characterized in that** the first transistor (T1) is made in a first well (4) and the second transistor (T2) in a second well (5), the said first and second wells being formed in the same substrate (1) and being separated by a thick oxide isolating region (I).

6. Protective circuit according to Claim 5, **characterized in that** the first terminal is electrically connected to the said same substrate (1).

7. Protective circuit according to any one of Claims 1 to 6, **characterized in that** the dielectric layers (C1, C2) of the control electrodes (K1, K2) of the said first and second transistors are made with a dielectric of identical nature to that used for producing the gates of the circuits to be protected.

8. Protective circuit according to Claim 7, **characterized in that** the central semiconductor regions located under the said dielectric layers (C1, C2) are doped over so as to raise the absolute value of the threshold voltage of the said first and second transistors.

9. Protective circuit according to any one of Claims 1 to 6, **characterized in that** the dielectric layers (C1, C2) of the control electrodes (K1, K2) of the said first and second transistors are formed by a thick oxide layer.

10. Protective circuit according to any one of Claims 1 to 9, **characterized in that** the said first and second transistors are p-type MOS transistors.

11. Protective circuit according to any one of Claims 1 to 9, **characterized in that** the said first and second transistors are n-type MOS transistors.
